# FASCICULE DE BREVET EUROPEEN

(11) **EP 0 408 511 B1**
(45) Date de publication et mention de la délivrance du brevet: **18.03.1998**
(21) Numéro de dépôt: 90810524.0
(22) Date de dépôt: 11.07.1990
(51) Int. Cl.: C23C 8/22, C21D 1/76

(54) **Procédé et installation de traitement thermique ou thermochimique d'un acier**
Verfahren und Vorrichtung zur thermischen oder thermochemischen Behandlung von Stahl
Process and apparatus for thermal or thermochemical treatment of steel

(30) Priorité: 13.07.1989 CH 2632/89; 14.12.1989 FR 8916541
(43) Date de publication de la demande: 16.01.1991
(73) Titulaire: SOLO FOURS INDUSTRIELS SA, CH-2555 Brügg b. Biel (CH)
(72) Inventeur: Gantois, Michel, F-54000 Nancy (FR)
(74) Mandataire: Patry, Didier Marcel Pierre

(56) Documents cités:
- EP-A- 0 080 124
- EP-A- 0 288 680
- DE-A- 3 139 622
- DE-A- 3 507 527
- GB-A- 2 202 238
- HÄRTEREI TECHNISCHE MITTEILUNGEN, vol. 31, no. 3, 1976, pages 132-137; J. WÜNNING et al.: "Gesteuerte Aufkohlung in CO-freien Atmosphären"

## Description

Le contrôle de la concentration du carbone à la surface d'un acier au cours d'un traitement thermique ou d'un traitement thermochimique en évitant des réactions complémentaires indésirables, comme l'oxydation par exemple, est un problème d'une grande importance industrielle dont la solution fait appel à la mise en oeuvre de solutions technologiques multiples.

Dans le cas du traitement thermique, la solution retenue pour les aciers très alliés, sensibles à l'oxydation, fait appel aux technologies du vide. Dans le cas des traitements thermochimiques, de cémentation par exemple, on met en oeuvre une réaction gaz-solide ou liquide-solide. Des espèces chimiques présentes dans la phase gazeuse ou dans la phase liquide se décomposent à la surface de l'acier, libérant le carbone qui diffuse dans le solide.

Dans les procédés de traitement thermique sous vide, on évite l'oxydation et la décarburation de l'acier en maintenant une pression totale de l'atmosphère du four très faible (inférieure à 0,1 mb).

Dans les procédés de cémentation les mieux contrôlés, on met l'acier au contact d'une atmosphère en équilibre thermodynamique dont le débit est suffisamment important pour que l'équilibre ne soit pas sensiblement modifié par le transfert du carbone dans le solide. Dans ce cas, l'espèce chimique de la phase gazeuse qui sert de support au carbone est l'oxyde de carbone CO. Sa décomposition à la surface de l'acier libère de l'oxygène dont la pression partielle doit être maintenue très basse.

Analysons en détail le problème de la cémentation des aciers.

Les vitesses de cémentation, c'est-à-dire les conditions qui permettent l'obtention du profil de concentration en carbone dans un temps le plus court possible, dépendent des vitesses de transfert des espèces chimiques dans la phase liquide ou dans la phase gazeuse (l'oxyde de carbone, par exemple, en phase gazeuse), des vitesses de transfert du carbone à l'interface liquide-solide ou gaz-solide, et de la diffusion du carbone en phase solide.

Dans les procédés conventionnels, l'étape limitative est celle correspondant au transfert du carbone à l'interface, soit parce que la réaction de décomposition des espèces chimiques est lente, soit parce que les produits de décomposition de ces espèces provoquent à la surface de l'acier une résistance au tranfert du carbone.

C'est ainsi que pour les procédés conventionnels de cémentation en phase gazeuse par l'oxyde de carbone, l'élimination de l'oxygène est trop lente, ce qui réduit de façon importante le flux de carbone transféré. Cela se traduit par le fait que la concentration superficielle en carbone, à la surface, n'atteint la valeur maximale, permettant la diffusion du carbone dans le solide à la vitesse optimale, qu'après plusieurs dizaines de minutes après sa mise en contact dans les conditions habituelles de température et de pression avec l'atmosphère appropriée.

On connaît déjà notamment par un article de M. J. Wünning et consorts, intitulé "Gesteuerte Aufkohlung" paru dans HTM 31 (1976) 3 et par le document DE-3 139 622, un procédé selon lequel certains paramètres sont mesurés durant la phase d'enrichissement en carbone et servent, après traitement, à déterminer des données de fonctionnement de l'installation.

Toutefois, l'enseignement contenu dans ces documents ne permet pas de conduire pratiquement un processus d'enrichissement en carbone dans le minimum de temps possible. En outre, le procédé connu se déroule à pression réduite.

Les recherches ayant conduit à la présente invention ont aboutit aux constatations suivantes:

Pour que le régime transitoire soit aussi court que possible, il faut que le flux de carbone transféré par la phase gazeuse et à l'interface gaz-solide soit supérieur puis égal au flux de carbone transféré dans la phase solide par diffusion pour une concentration de surface en carbone maximale. Il faut pour cela disposer:
- d'un composé chimique vecteur du carbone dans la phase gazeuse ayant une cinétique de décomposition à la surface de l'acier très rapide,
- d'un réacteur ayant un comportement de réacteur parfaitement agité,
- d'une réaction gaz-solide permettant d'éviter toute formation d'une résistance de transfert à la surface de l'acier.

Cette résistance de transfert peut être constituée soit par une couche d'éléments chimiques adsorbés résultant de la décomposition des espèces chimiques vecteurs du carbone, soit par la formation d'une couche continue d'un composé défini (carbure) dans lequel la diffusion du carbone est lente.

Si l'on évite l'apparition de cette résistance de tranfert, si la décomposition à la surface de l'acier, de la molécule assurant le transfert du carbone dans la phase gazeuse est très rapide, si le débit de carbone à l'entrée du réacteur est suffisant et si le réacteur est parfaitement agité, le flux de carbone transféré dans l'acier est maximal et la vitesse d'élaboration du gradient de concentration en carbone dans l'acier ne dépend que de la diffusion du carbone dans l'état solide.

Lorsque ces conditions sont réunies, la concentration en carbone en surface d'un acier ayant initialement une concentration en carbone de 0,2 % atteint sa valeur optimale (une valeur au moins égale à la concentration à saturation de l'austénite), en moins d'une minute, temps qu'il faut comparer aux plusieurs dizaines de minutes nécessaires dans le cas d'un procédé conventionnel de cémentation par l'oxyde de carbone.

Le traitement de cémentation par le carbone s'effectue dans ce cas à une vitesse optimale.

La présente invention vise donc à définir des moyens pratiques permettant d'atteindre ce résultat d'une manière industrielle.

Elle a pour objet un procédé de traitement thermique ou thermochimique d'un acier conforme à celui défini par la revendication 1 du brevet.

Un autre objet de l'invention est une installation d'enrichissement en carbone de la zone superficielle de pièces en acier conforme à celle définie à la revendication 11 du brevet.

On réalise ces conditions en utilisant un mélange gazeux qui ne contient pas d'oxygène, constitué d'un gaz ou d'un mélange gazeux support inerte chimiquement, d'un gaz ou d'un mélange gazeux permettant d'éviter tout phénomène d'oxydation pendant les périodes du cycle de traitement où le flux de carbone à la surface de la pièce est nul, d'un gaz ou d'un mélange gazeux permettant le transfert du carbone et constitué de deux composés exempts d'oxygène. Le gaz ou le mélange gazeux permettant le transfert du carbone contient au moins un composé chimique dont la pyrolyse à la surface de l'acier libère du carbone et conduit à la formation d'un mélange de sous-produits stables chimiquement dans la phase gazeuse, dans les conditions de température et de pression considérées. Ainsi, le flux de carbone transféré peut être piloté par le débit du composé pyrolysable introduit dans le réacteur.

On va décrire ci-après, à titre d'exemple, comment l'objet de l'invention peut être réalisé pratiquement. Les dessins annexés représentent :
la fig. 1, une installation pour l'élaboration des données de base de la mise en oeuvre du procédé,
la fig. 2, un graphique comparatif d'enrichissement en carbone effectué selon différentes méthodes,
les fig. 3 et 5, des graphiques illustrant des exemples de mise en oeuvre du procédé, à deux températures différentes,
la fig. 4, une vue schématique d'une installation pour la mise en oeuvre du procédé, et
la fig. 6, un graphique auxiliaire relatif à l'exemple de la fig. 5.

En pratique, le traitement peut être réalisé de la façon suivante:
- une première phase (I) à la température maximale possible, définie à partir de critères métallurgiques, avec pilotage du débit d'entrée d'hydrocarbures pour obtenir une concentration maximale du carbone en surface, cette concentration maximale étant au moins égale à la concentration en carbone à saturation de l'austénite;
- une deuxième phase (II) à la température maximale possible, définie à partir de critères métallurgiques, durant laquelle le flux de carbone transféré depuis la phase gazeuse est nul afin d'ajuster le profil de concentration en carbone et en particulier la concentration en surface, à une valeur prédéterminée, choisie pour des raisons métallurgiques. Dans de nombreux cas, cette valeur est voisine de 0,7/0,8% sur les aciers de cémentation conventionnels.

A la fin de cette deuxième phase, la température peut être celle choisie pour réaliser la trempe de l'acier.

Il est possible de réaliser un cycle par une succession appropriée de phases I et de phases II dont le nombre et la durée dépendent du profil de concentration en carbone souhaité. Toutefois, dans ce cas, la durée totale du cycle sera plus importante que dans le cas d'un cycle comportant seulement une phase I et une phase II.

La phase I nécessite un contrôle précis de la concentration superficielle en carbone à partir du flux de carbone consommé par l'acier. Ce flux de carbone est lui-même contrôlé par le débit d'hydrocarbures introduits dans le réacteur. Si la concentration en carbone à la surface de l'acier est connue, le débit de carbone consommé est facilement calculé. Inversement, le contrôle continu du débit de carbone consommé permet de maintenir constante une concentration superficielle en carbone. Le débit de carbone consommé est obtenu en faisant le bilan matière du réacteur, soit après une identification préalable des différentes espèces chimiques formées, ainsi que l'évolution de leur concentration, soit par une analyse à chaque instant du mélange gazeux sortant du réacteur. La deuxième solution évite des incertitudes d'un modèle physicochimique et elle permet de contrôler à chaque instant le fonctionnement du réacteur et l'évolution de la réaction gaz-solide.

Un contrôle parfait de la concentration superficielle en carbone pendant la phase I est indispensable pour connaître avec précision le profil de concentration en carbone dans l'acier à la fin de cette phase. En effet, c'est à partir de ce profil que l'on déterminera la durée de la phase II pour obtenir, à la fin de celle-ci, le profil de concentration en carbone final souhaité pour des raisons métallurgiques (profil de microdureté - concentration de contraintes de compression en surface - teneur en austénite résiduelle).

Comme nous l'avons indiqué plus haut, le contrôle à une valeur constante de la concentration superficielle en carbone de l'acier peut être obtenu par le pilotage du débit d'entrée de l'hydrocarbure dans le réacteur à partir d'un bilan carbone réalisé sur le réacteur se comportant comme un réacteur parfaitement agité. Il faut toutefois, déterminer avec suffisamment de précision le moment où cette concentration de surface maximale est atteinte à la fin de la période transitoire qui apparaît au début du traitement.

Une solution élégante à ce problème consiste à former à la surface de l'acier une couche de carbure de fer (appelée cémentite) dès le début de la diffusion du carbone en introduisant dans le mélange support (azote - hydrogène par exemple), une proportion convenable d'un mélange d'hydrocarbures tels que : acétylène, méthane éthylène, éthane. Ce mélange permet la croissance très rapide d'une couche mince de cémentite à la surface de l'acier. Cette couche mince dont l'épaisseur est de 1 micromètre, fixe la concentration en carbone à l'interface cémentite-acier à la valeur exacte de la concentration à saturation du carbone dans l'austénite à la température considérée. La diffusion du carbone dans l'acier est donc contrôlée par l'existence de cette couche de cémentite. C'est elle qui fournit le carbone qui diffuse dans l'acier. Il suffit que le carbone consommé par l'acier soit compensé par la reconstitution de la couche de cémentite qui s'alimente en carbone auprès des hydrocarbures de la phase gazeuse.

Ce procédé qui conduit à la formation très rapide en début de traitement (moins d'une minute), d'une couche de cémentite permet une diffusion du carbone auto-contrôlée.

La composition du mélange gazeux qui permet la croissance rapide de la couche de cémentite peut être réalisée par une addition convenable d'un seul hydrocarbure, le propane, dont la décomposition au contact de l'acier permet d'obtenir le mélange gazeux souhaité, contenant en particulier et de façon non exclusive du méthane, de l'éthane, de l'éthylène et de l'acétylène.

Une fois la couche de cémentite formée, on règle de manière permanente son alimentation en carbone de façon à ce que celle-ci compense le carbone consommé par l'acier. Un régime de transfert dynamique s'établit ainsi entre la phase gazeuse - la couche de cémentite - l'acier.

Dans ces conditions, pour un acier donné, la température est le seul paramètre qui contrôle le transfert du carbone dans l'acier.

L'ajustement du profil de concentration en carbone final peut nécessiter pendant la phase II le transfert partiel du carbone du solide vers la phase gazeuse. Le mélange gazeux doit à cet effet contenir un constituant susceptible de se combiner au carbone pour former des hydrocarbures, assurant ainsi au mélange gazeux une fonction décarburante.

Le mélange gazeux support doit donc assurer trois fonctions:
- éviter toute oxydation pendant toutes les phases où le flux de carbone du mélange gazeux vers le solide est nul;
- former avec les produits de décomposition de l'hydrocarbure introduit pendant la cémentation proprement dite, un mélange chimiquement apte à former une couche de cémentite permettant d'assurer le transfert du carbone dans l'acier.
- assurer éventuellement après la phase I une fonction de décarburation partielle de la surface de l'acier.

Ces trois fonctions peuvent être obtenues en utilisant un support gazeux constitué d'un mélange convenable d'azote et d'hydrogène.

Les principes exposés ci-dessus peuvent être démontrés quantitativement à l'aide de mesures thermogravimétriques avec traitement automatique des mesures et pilotage automatique des débits gazeux.

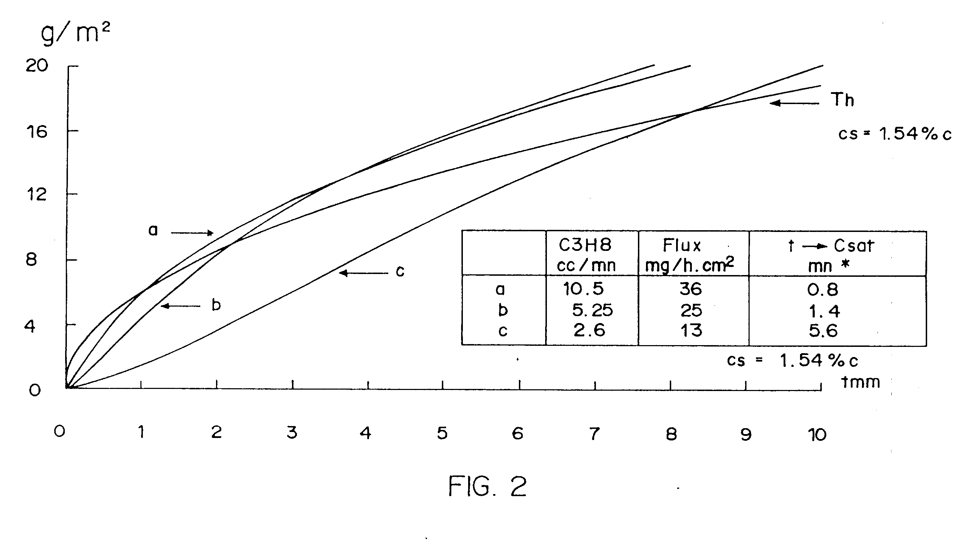

On constate, par exemple, que les flux peuvent être réglés à volonté, soit à une valeur constante (courbes a, b, c figure 2) soit en les faisant varier, de telle sorte que la concentration superficielle en carbone soit constante (courbe Th figure 2).

Le tableau I donne pour des concentrations superficielles égales à la concentration à saturation de l'austénite les flux instantanés et les flux moyens. Ces flux sont à comparer à ceux que l'on obtient au cours de traitements conventionnels par l'oxyde de carbone et qui atteignent au mieux 3,5 mg/h cm² à 950 degrés C environ.

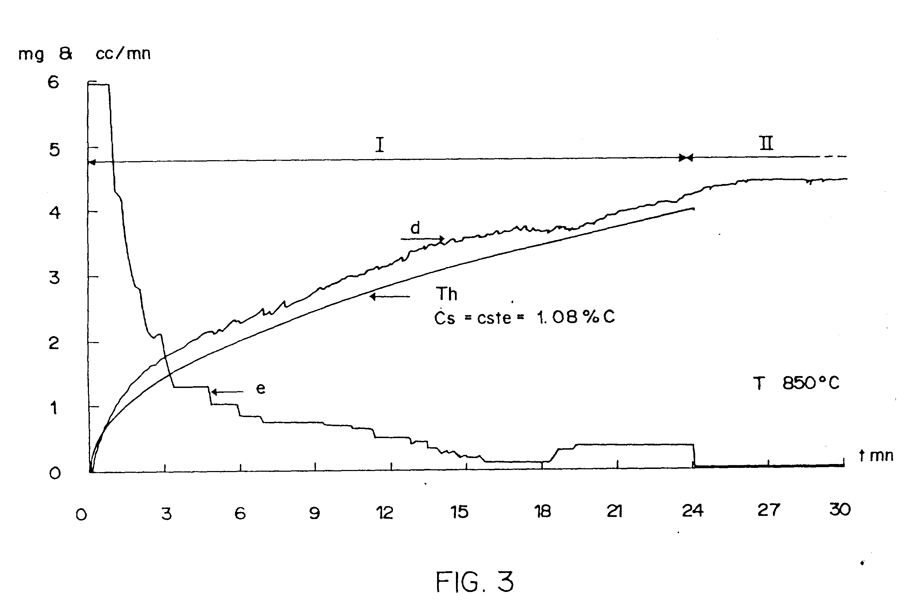

On constate sur la courbe fig. 3 correspondant à une cémentation à 850 degrés C que l'algorithme de pilotage du débit de propane permet de réaliser une absorption du carbone à concentration superficielle constante dès les premiers instants du traitement. En fait, quelle que soit la température entre 800 degrés C et 1100 degrés C, les conditions de DIRICHLET (concentration à la surface constante) sont atteintes en moins d'une minute, alors que la cémentation par le CO nécessite plusieurs dizaines de minutes (couramment environ 1 heure pour les concentrations de surface supérieure à 1% C au-delà de 900 degrés C).

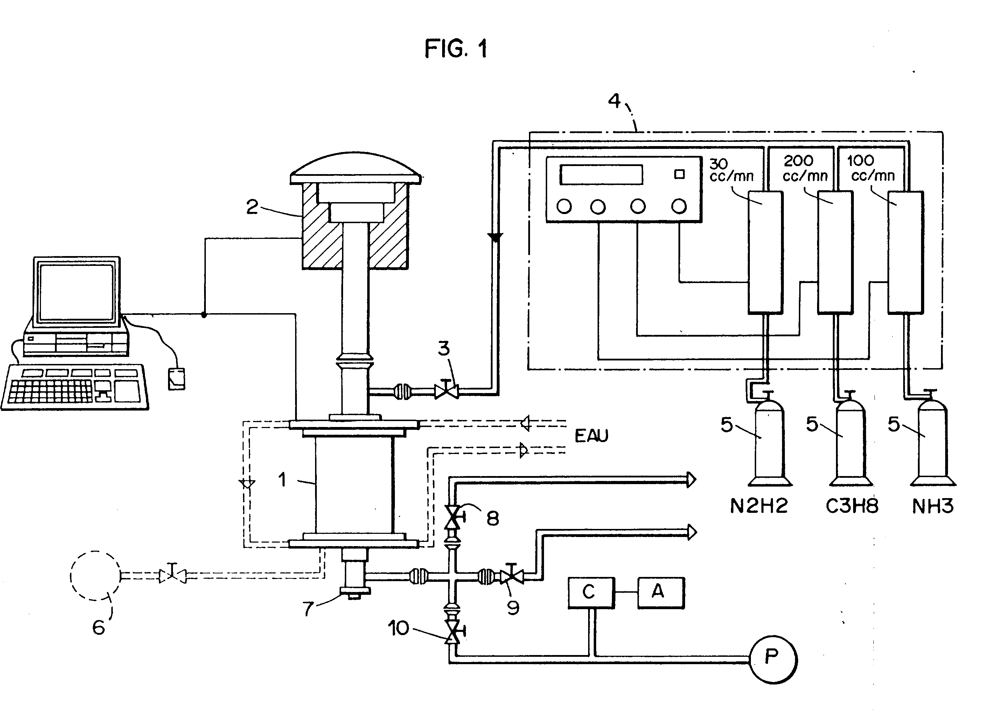

La fig. 1 représente schématiquement des moyens de mesure permettant de relever des données nécessaires au pilotage d'un traitement. Un ensemble 1 constitué d'un four et d'une chambre d'analyse est associé à une balance 2. Le four est alimenté à travers une vanne 3 à partir d'un régulateur de débit massique 4, par des gaz contenus dans des bouteilles 5, ici au nombre de trois. Une pompe 6 assure la circulation du gaz et maintient la pression dans le four. Un thermo-couple 7 contrôle la température. Des sorties de gaz 8, 9 et 10 permettent l'évacuation de ceux-ci, la sortie 9 étant connectée à un appareil d'analyse chromatographique et la sortie 10 à un capteur de pression C et à une pompe P. Une alimentation est possible en A. Cette installation permet d'effectuer le bilan matière du réacteur, soit par identification des espèces chimiques formées, et détection de l'évolution de leur concentration, soit par analyse continue du mélange gazeux sortant du réacteur.

Les courbes de la fig. 2, qui correspondent à certains cas particuliers, donnent les quantités de carbone, en gramme par mètre carré, qui ont pénétré dans la surface de l'acier, en fonction du temps d'exposition. Les courbes a, b et c correspondent à différentes conditions opératoires comportant toutes le balayage de l'acier à 1000°C par un flux gazeux dans lequel le débit du gaz de support est de 100 cc/min. La courbe Th (courbe théorique) donne les quantités de carbone ayant pénétré dans l'acier au temps t dans des conditions comparables, lorsque l'on impose au flux gazeux la condition que son débit est constamment tel, qu'il maintient la concentration superficielle en carbone à une valeur constante cs = 1,54%, valeur qui correspond à la saturation.

Les temps mis pour atteindre la saturation dans chacune des conditions définies, pour le flux, par les courbes a, b et c, sont respectivement 0,8 1,4 et 5,6 min.

Les courbes de la fig. 3 illustrent un exemple de mise en oeuvre du procédé de l'invention. Des pièces de dimension prédéterminée sont placées dans un four à 850°C. La courbe Th donne, comme à la fig. 2 les quantités de carbone qui selon le calcul ont pénétré dans l'acier en fonction du temps, si la condition de concentration superficielle égale à la saturation est maintenue de manière permanente. La courbe d reproduit un enregistrement qui a été effectivemnt réalisé au cours de la mise en oeuvre du procédé tandis que la courbe e donne en fonction du temps les débits de propane dans le mélange gazeux, tels qu'ils ont été obtenus par le pilotage de l'opération. Ces débits sont donnés en cc/min. La courbe d est une conséquence de la courbe e.

La phase d'enrichissement se termine après 24 min. La valeur de la teneur en C correspondant à la saturation est cs = 1,08% C. Durant la phase de diffusion, qui suit l'enrichissement, le débit de propane est amené à zéro. La quantité de C qui pénètre dans l'acier reste tout d'abord constante pour diminuer ensuite.

On voit que la courbe d se place légèrement au-dessus de la courbe Th dès que la saturation a été obtenue soit après moins d'une minute. On réalise ainsi la formation rapide d'une mince couche de cémentite qui régularise la diffusion du carbone en profondeur.

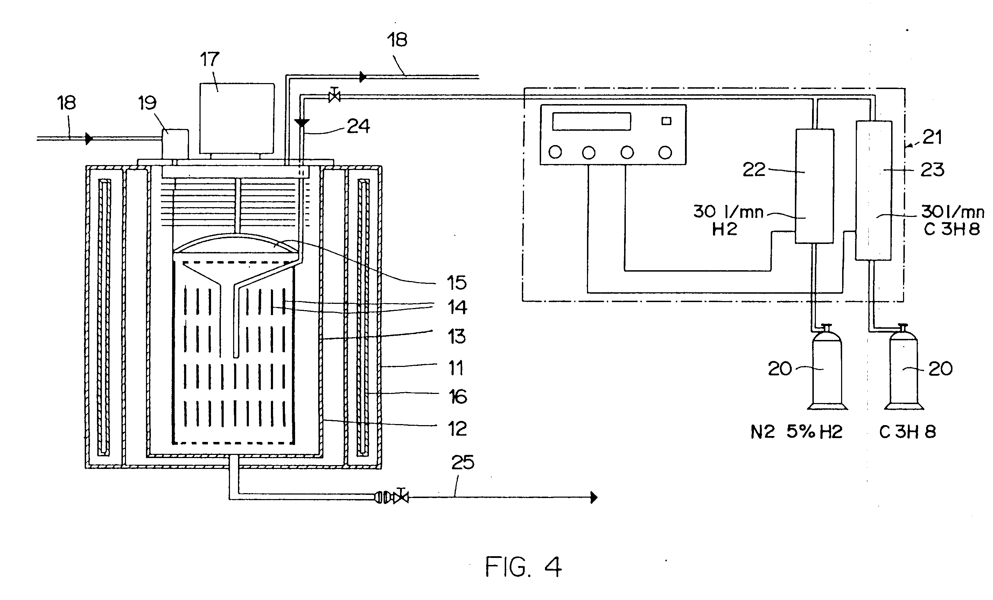

La fig. 4 représente schématiquement une installation assurant la réalisation du procédé dans un cas où les données de pilotage du mélange gazeux ont été mémorisées ou introduites sous forme d'un algorithme dans le régulateur.

Le four 11 comporte un moufle 12, un pot intérieur 13, une charge de pièces 14, une turbine 15. Il est équipé de résistances de chauffage 16, d'un moteur 17, d'un circuit d'eau de refroidissement 18 contrôlé par un thermocouple 19. Le flux gazeux entrant en 24 et sortant en 25 est constitué d'un flux porteur N₂ + 5% H₂ et d'un flux d'apport de carbone C₃H₈. Ces flux proviennent des bouteilles 20. Ils peuvent atteindre un débit de 30 1/min. Le régulateur 21 actionne, en fonction des paramètres de commande, des vannes 22 et 23 réglant séparément en fonction du temps les débits des bouteilles. Le régulateur 21 agit sous l'influence de données qui peuvent avoir été élaborées par l'appareillage de la fig. 1.

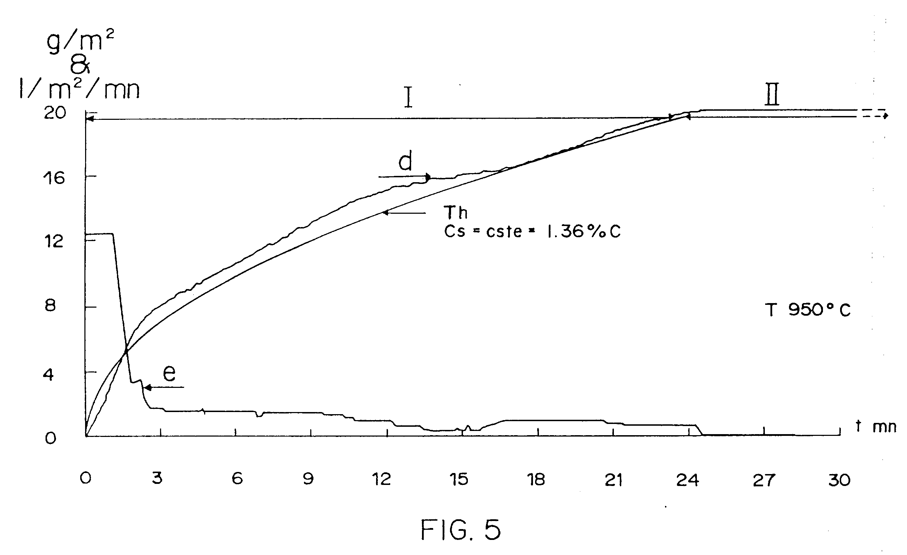

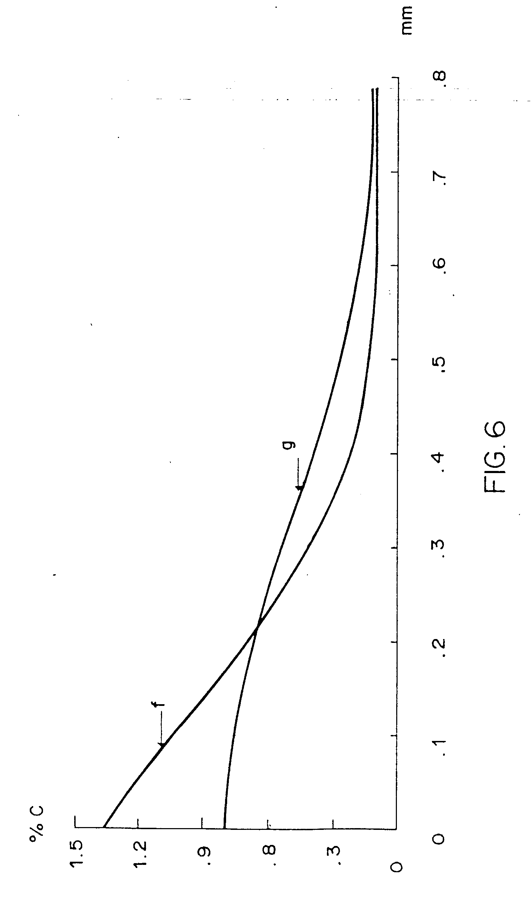

Les graphiques des fig. 5 et 6 se rapportent à un autre exemple de mise en oeuvre du procédé. Les courbes Th, d et e de cette fig. 5 ont la même signification qu'à la fig. 3. Les indications portées en ordonnées sont respectivement des masses de carbone ayant pénétré dans la surface des pièces, en grammes par mètre carré et des débits de gaz en litres par mètre carré et minute. La première échelle se rapporte aux courbes Th et d, la seconde à la courbe e. La cémentation a été effectuée à 950°C. La teneur en C à saturation est cs = 1,36%, chiffre qui détermine ici la courbe théorique Th.

Après une phase d'enrichissement qui dure 24 min, comme le montre la fig 5, la phase de diffusion se déroule comme l'illustre la fig. 6 qui est un graphique classique reproduisant des profils de concentration en profondeur. La courbe f donne dans les conditions de l'exemple de la fig. 5 le profil des concentrations en C à la fin de la phase d'enrichissement soit après 24 min. La courbe g est un relevé du profil des concentrations après 22 min. de diffusion. La teneur en C est d'environ 0,8% à la surface et 0,1% à une profondeur de 0,62 mm environ.

La figure 4 montre le schéma de principe d'un réacteur industriel permettant la mise en oeuvre de ce traitement. De nombreuses autres géométries de réacteur sont compatibles avec ce traitement, on peut évidemment lui adjoindre les dispositifs habituels de trempe des aciers soit en milieu liquide (huile, eau, etc.), soit en milieu gazeux.

La figure 5 donne l'enregistrement d'un traitement typique conduit à 950°C avec une première phase de 24 minutes réalisée à concentration superficielle constante de 1,38% de carbone suivie d'une phase de diffusion permettant d'obtenir une concentration superficielle en fin de traitement de 0,8%C.

La figure 6 donne les profils de concentration en carbone obtenus.

En résumé, le procédé décrit présente les éléments important suivants:
I. Il permet le contrôle permanent et instantané du flux de carbone transféré à la surface d'un acier à l'aide d'une atmosphère gazeuse assurant le contrôle instantané et permanent de la concentration de carbone à la surface de l'acier.
II. Il permet, outre le contrôle de la concentration en carbone à la surface de l'acier, d'éviter toute oxydation, même des éléments d'alliages les plus oxydables des aciers. Il est applicable aux traitements thermiques des aciers alliés, à la carburation parfois appelée cémentation, à la carbonitruration des aciers.
III. Il englobe un procédé de cémentation (ou de carburation) accélérée des aciers à l'aide d'un mélange gazeux contenant un ou plusieurs hydrocarbures permettant, dans des conditions de pression variées et en particulier à la pression atmosphérique, de contrôler le flux de carbone absorbé par l'acier à partir du contrôle du débit d'hydrocarbures injectés dans le mélange gazeux.
IV. Le procédé de cémentation accélérée permet de maintenir la concentration superficielle en carbone à la valeur la plus élevée possible compatible avec la température de l'acier pour obtenir le flux de carbone maximum permettant l'enrichissement de la surface en carbone pendant le temps le plus court possible.
V. Ce procédé de cémentation accélérée est caractérisé par une phase de diffusion du carbone dans l'acier au cours de laquelle le flux de carbone transféré du gaz vers l'acier est nul, permettant ainsi d'ajuster le profil de concentration en carbone à partir de la surface et selon certains critères métallurgiques. Au cours de cette phase la fine couche de cémentite disparaît puisqu'elle n'est plus alimentée en carbone par la phase gazeuse.
VI. Il est également caractérisé, le cas échéant, par une phase de diffusion du carbone dans l'acier au cours de laquelle un flux de carbone contrôlé est transféré de l'acier vers la phase gazeuse permettant ainsi d'ajuster le profil de concentration en carbone à partir de la surface et selon certains critères métallurgiques.
VII. Dans certains cas, le procédé permet de réaliser le traitement le plus court possible en deux phases seulement:
   - une phase d'enrichissement à vitesse maximum,
   - une phase de diffusion.

Le procédé permet aussi de réaliser plus lentement le traitement conduisant au même profil de concentration en carbone à l'aide de plusieurs phases d'enrichissement et de diffusion alternées combinées entre elles de différentes façons.
VIII. Il est possible d'introduire de l'azote à la surface de l'acier simultanément à la diffusion du carbone. Il suffit d'introduire dans le mélange gazeux une quantité convenable d'ammoniac. On réalise alors un traitement de carbonitruration auto-contrôlé à la vitesse maximale de diffusion du carbone et de l'azote.
IX. Utilisation d'un mélange gazeux support permetant d'éviter l'oxydation de l'acier à l'une quelconque des phases de traitement et constitué en particulier d'un mélange en proportion convenable d'azote et d'hydrogène.
X. Possibilité de contrôler le flux de carbone à l'aide du contrôle du débit de propane introduit dans le mélange azote hydrogène.
XI. L'installation pour la mise en oeuvre du procédé peut utiliser tous les types de fours batch ou continus fonctionnant à basse ou à haute pression et en particulier à la pression atmosphérique, pouvu que l'atmosphère gazeuse soit parfaitement agitée.
XII. Le contrôle du flux de carbone ou de la concentration superficielle en carbone est obtenu de façon automatique par le pilotage couplé de la température de l'acier et du débit d'hydrocarbure et en particulier du propane.

Une installation pilotée automatiquement permet la cémentation des aciers à la vitesse maximale à la pression atmosphérique.

Elle évite totalement toute formation et donc tout rejet d'oxyde de carbone et de gaz carbonique.

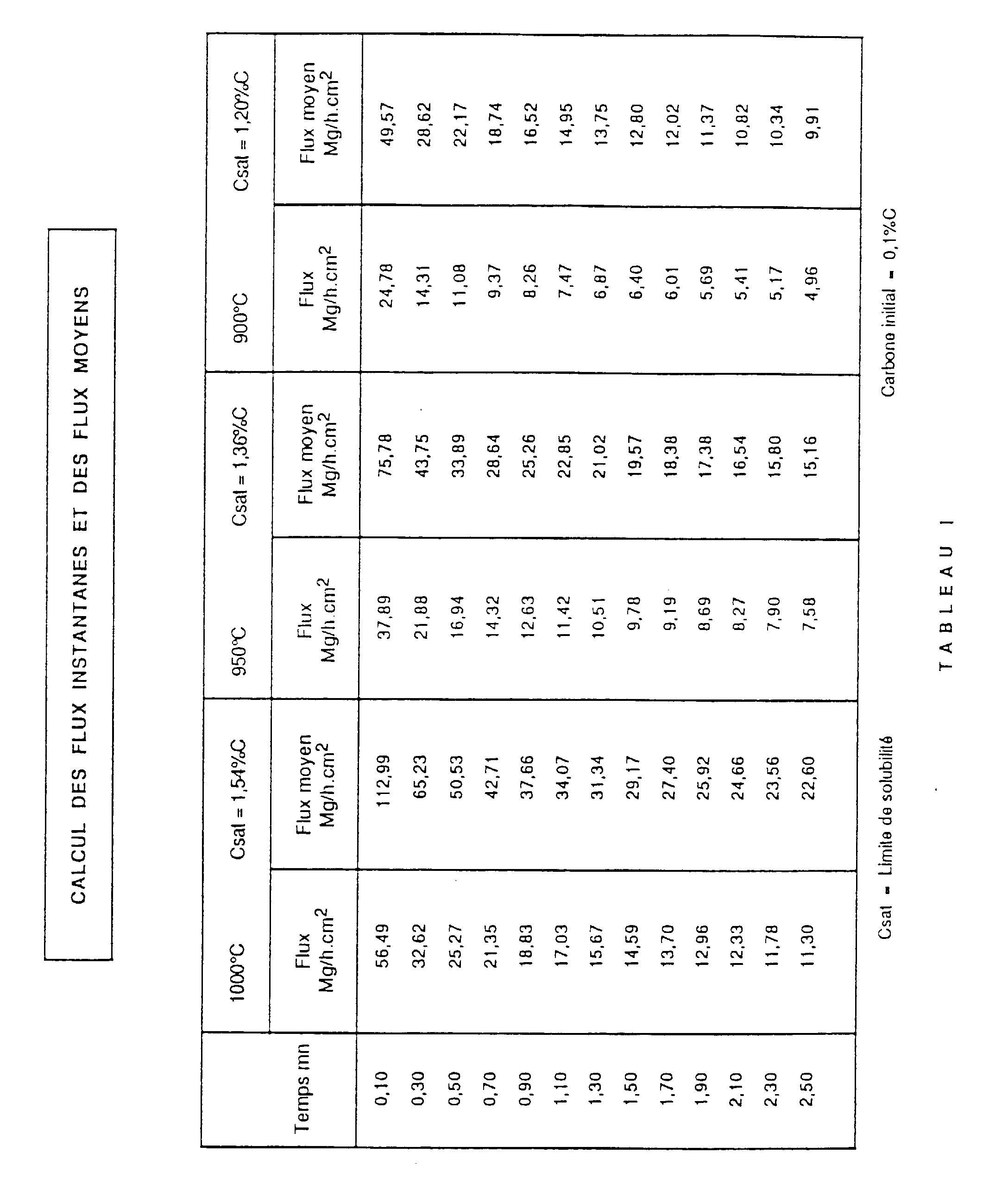

## Revendications

1. Procédé de traitement thermique ou thermochimique de pièces en acier, dans lequel on place ces pièces à l'intérieur d'un four, on les maintient à une température déterminée, on fait circuler dans le four un flux gazeux qui comporte un constituant d'apport de carbone formé d'au moins un hydrocarbure, et on règle le débit du constituant d'apport de carbone dans le flux de manière à réaliser au moins une première phase de traitement causant un enrichissement de l'acier des pièces en carbone, chaque première phase de traitement causant un enrichissement de l'acier des pièces en carbone, chaque première phase étant suivie d'une seconde phase causant une diffusion du carbone dans l'acier,
caractérisé en ce que chaque première phase est divisée en deux périodes se succédant immédiatement,
la première période étant déterminée par le fait que le débit du constituant d'apport du carbone a une valeur constante qui permet de former à la surface de l'acier une fine couche de cémentite qui permet de fixer la concentration superficielle en carbone à une valeur égale à la concentration à saturation qui dépend de la composition de l'acier et de la température, cette première période correspondant à la formation de la cémentite à la vitesse maximale liée audit hydrocarbure,
cette première période étant interrompue par un abaissement instantané du débit du constituant d'apport de carbone au moment où la concentration superficielle atteint une valeur égale à la saturation,
le débit du constituant d'apport de carbone étant alors, au cours de la deuxième période, amené et réglé en permanence à une valeur variable apte à maintenir la concentration superficielle à la valeur de saturation,
la seconde période durant jusqu'à la fin de la première phase.

2. Procédé selon la revendication 1, caractérisé en ce que la valeur constante du débit du constituant d'apport de carbone durant la première période est telle que la saturation est obtenue après environ une minute.

3. Procédé selon la revendication 1, caractérisé en ce que la valeur constante du débit du constituant d'apport de carbone durant la première période est telle que ladite mince couche de cémentite se forme à la surface de l'acier dès le début de ladite première période.

4. Procédé selon la revendication 1, caractérisé en ce que le flux gazeux comporte, outre ledit constituant d'apport de carbone, un support constitué d'azote.

5. Procédé selon la revendication 1, caractérisé en ce que ledit flux gazeux comporte, outre ledit constituant d'apport de carbone, un support constitué d'hydrogène et d'azote.

6. Procédé selon l'une des revendications 4 et 5, dans lequel l'hydrocarbure est du propane et le mélange d'hydrocarbures contient du méthane, de l'éthane, de l'acétylène ou de l'éthylène.

7. Procédé selon l'une des revendications 1 à 6, caractérisé en ce que l'enrichissement de la surface en carbone est obtenu pendant le temps le plus court possible et la concentration superficielle en carbone est maintenue à la valeur la plus élevée possible, quelle que soit la pression du mélange gazeux et en particulier à la pression atmosphérique.

8. Procédé selon l'une quelconque des revendications 1 à 7, caractérisé en ce que le flux gazeux est réglé de manière à varier en fonction du temps selon au moins un cycle comprenant une première période durant laquelle le flux obéit à la condition que la concentration superficielle en carbone atteigne et conserve une première valeur qui est une valeur limite prédéterminée, et une seconde période durant laquelle l'apport de carbone est nul et la concentration superficielle diminue par diffusion du carbone en profondeur dans la pièce, la durée de cette deuxième période étant déterminée par la condition que la concentration superficielle atteint une deuxième valeur qui est une valeur prescrite, également prédéterminée.

9. Procédé selon la revendication 8, caractérisé en ce que le réglage du flux porte sur le débit d'un hydrocarbure contenu dans un mélange de gaz formant ledit flux.

10. Procédé selon la revendication 8 ou la revendication 9, caractérisé en ce que le réglage du flux est effectué à partir de données mémorisées relatives aux températures, aux types de pièces, aux pressions et compositions du flux gazeux, les données déterminant les temps et les valeurs de réglage du flux gazeux et la possibilité d'obtenir un profil de concentration en carbone prédéterminé à la surface de l'acier à la vitesse maximale théorique.

11. Installation d'enrichissement en carbone de la zone superficielle de pièces en acier pour la mise en oeuvre du procédé selon l'une des revendications 1 à 10, comprenant
un four à atmosphère contrôlée avec une entrée et une sortie pour un flux gazeux,
des moyens d'alimentation capables de conduire dans le four une circulation d'un flux gazeux avec un constituant de support et un constituant d'apport de carbone formé d'au moins un hydrocarbure,
des moyens de manoeuvre permettant de définir et faire varier les débits desdits constituants,
des moyens de commande des moyens de manoeuvre,
et des moyens de fourniture de données pilotant lesdits moyens de commande,
caractérisée en ce que les moyens d'alimentation, les moyens de manoeuvre et les moyens de commande sont agencés de manière à être capables de former et régler, les débits et lesdits constituants au cours d'une phase d'enrichissement en carbone dans laquelle le constituant d'apport de carbone provoque une augmentation de la concentration superficielle des pièces à une valeur égale à la saturation en environ une minute, puis le débit du constituant d'apport de carbone est abaissé instantanément à une valeur assurant le maintien de ladite valeur de concentration superficielle, puis ledit débit est soumis à un réglage qui fait varier sa valeur de manière à maintenir la concentration superficielle à ladite valeur égale à la saturation.

12. Installation selon la revendication 11, caractérisée en ce que lesdits moyens de fourniture de données sont des moyens de mémorisation de données, ou des moyens de calcul de données.

13. Installation selon la revendication 11, caractérisée en ce que les moyens d'alimentation sont conçus de manière à conférer au four le comportement d'un réacteur parfaitement agité.

## Patentansprüche

1. Verfahren zur thermischen oder thermochemischen Behandlung von Teilen aus Stahl, bei dem man die Teile in einen Ofen einsetzt, sie auf einer bestimmten Temperatur hält, in dem Ofen einen Gasfluß zirkulieren läßt, der einen Bestandteil für Kohlenstoffzufuhr umfaßt, gebildet von mindestens einem Kohlenwasserstoff, und der Durchsatz des Kohlenstoff übertragenden Bestandteils in dem Fluß derart geregelt wird, daß mindestens eine erste Behandlungsphase eine Anreicherung des Stahls der Teile mit Kohlenstoff bewirkt, wobei jede erste Behandlungsphase eine Anreicherung des Stahls der Teile mit Kohlenstoff bewirkt, wobei jeder ersten Phase eine zweite Phase folgt, die eine Diffusion des Kohlenstoffs in den Stahl bewirkt,
**dadurch gekennzeichnet,** daß jede erste Phase in zwei einander unmittelbar folgende Perioden unterteilt ist, welche erste Periode durch die Tatsache bestimmt ist, daß der Durchsatz des Kohlenstoff übertragenden Bestandteils einen konstanten Wert hat, der es ermöglicht, an der Oberfläche des Stahls eine feine Zementitschicht zu bilden, die die Fixierung der Oberflächenkonzentration an Kohlenstoff auf einen Wert ermöglicht, der gleich der Sättigungskonzentration ist, welche von der Zusammensetzung des Stahls und der Temperatur abhängt, welche erste Periode der Bildung des Zementits mit der Maximalgeschwindigekeit in Verbindung mit dem Kohlenwasserstoff entspricht,
welche erste Periode durch eine augenblickliche Absenkung des Durchsatzes des Kohlenstoff übertragenden Bestandteils in dem Augenblick unterbrochen wird, in dem die Oberflächenkonzentration einen Wert gleich der Sättigung erreicht,
wobei der Durchsatz des Kohlenstoff übertragenden Bestandteils demgemäß während der zweiten Periode permanent auf einen variablen Wert gebracht und geregelt wird, um die Oberflächenkonzentration bei dem Sättigungswert zu halten,
welche zweite Periode bis zum Ende der ersten Phase dauert.

2. Verfahren nach Anspruch 1, dadurch gekennzeichnet, daß der konstante Wert des Durchsatzes des Kohlenstoff übertragenden Bestandteils während der ersten Periode derart ist, daß die Sättigung nach etwa einer Minute erreicht wird.

3. Verfahren nach Anspruch 1, dadurch gekennzeichnet, daß der konstante Wert des Durchsatzes des Kohlenstoff übertragenden Bestandteils während der ersten Periode derart ist, daß die dünne Zementitschicht sich auf der Oberfläche des Stahls ab dem Beginn der ersten Periode bildet.

4. Verfahren nach Anspruch 1, dadurch gekennzeichnet, daß der Gasfluß neben dem Kohlenstoff übertragenden Bestandteil einen von Stickstoff gebildeten Träger umfaßt.

5. Verfahren nach Anspruch 1, dadurch gekennzeichnet, daß der Gasfluß neben dem Kohlenstoff übertragenden Bestandteil einen Stützanteil umfaßt, gebildet von Wasserstoff und Stickstoff.

6. Verfahren nach einem der Ansprüche 4 und 5, bei dem der Kohlenwasserstoff Propan ist und bei dem das Gemisch von Kohlenwasserstoffen Methan, Äthan, Acethylen oder Äthylen umfaßt.

7. Verfahren nach einem der Ansprüche 1 bis 6, dadurch gekennzeichnet, daß die Kohlenstoffanreicherung der Oberfläche während der kürzestmöglichen Zeit erreicht wird und die Kohlenstoffoberflächenkonzentration auf dem höchstmöglichen Wert gehalten wird, unabhängig von dem Druck des Gasgemisches und insbesondere bei Atmosphärendruck.

8. Verfahren nach einem der Ansprüche 1 bis 7, dadurch gekennzeichnet, daß der Gasfluß derart geregelt wird, daß er in Abhängigkeit von der Zeit gemäß mindestens einem Zyklus variiert wird, umfassend eine erste Periode, während der der Fluß der Bedingung folgt, daß die Oberflächenkonzentration an Kohlenstoff einen ersten Wert erreicht und beibehält, der ein vorbestimmter Grenzwert ist, und eine zweite Periode, während welcher die Kohlenstoffzufuhr null ist und die Oberflächenkonzentration durch Diffusion des Kohlenstoffs in die Tiefe des Teils abnimmt, wobei die Dauer dieser zweiten Periode durch die Bedingung bestimmt wird, daß die Oberflächenkonzentration einen zweiten Wert erreicht, der ein vorgeschriebener und vorbestimmter Wert ist.

9. Verfahren nach Anspruch 8, dadurch gekennzeichnet, daß die Regelung des Flusses auf den Durchsatz eines Kohlenwasserstoffgehalts in einem Gemisch von Gas einwirkt, das den Fluß bildet.

10. Verfahren nach Anspruch 8 oder Anspruch 9, dadurch gekennzeichnet, daß die Regelung des Flusses ausgehend von Daten erfolgt, die relativ zu den Temperaturen, den Typen von Teilen, den Drücken und Zusammensetzungen des Gasflusses abgespeichert sind, welche Daten die Zeiten und die Einstellwerte des Gasflusses und die Möglichkeit, ein vorbestimmtes Kohlenstoffkonzentrationsprofil an der Oberfläche des Stahls mit maximaler theoretischer Geschwindigkeit zu erzielen, bestimmen.

11. Anlage zum Anreichern der Oberflächenzone von Teilen aus Stahl mit Kohlenstoff für die Ausführung des Verfahrens gemäß einem der Ansprüche 1 bis 10, umfassend
einen Ofen mit gesteuerter Atmosphäre mit einem Einlaß und einem Auslaß für einen Gasfluß,
Speisemittel, die in der Lage sind, in dem Ofen eine Zirkulation eines Gasflusses mit einem Stützbestandteil und einem Kohlenstoff übertragenden Bestandteil, gebildet von mindestens einem Kohlenwasserstoff, zu führen,
Manövriermittel, die es ermöglichen, die Durchsätze der Bestandteile zu definieren und zu variieren,
Steuermittel für die Manövriermittel, und
Mittel zum Liefern von Daten, die die Steuermittel ansteuern,
**dadurch gekennzeichnet,** daß die Versorgungsmittel, die Manövriermittel und die Steuermittel derart ausgebildet sind, daß sie in der Lage sind, die Durchsätze und die Bestandteile während einer Kohlenstoffanreicherungsphase zu bilden und zu regeln, in der der Kohlenstoff übertragende Bestandteil einer Erhöhung der Oberflächenkonzentration der Teile auf einen Wert gleich der Sättigung in etwa einer Minute hervorrufen, danach der Durchsatz des Kohlenstoff übertragenden Bestandteils augenblick auf einen Wert abgesenkt wird, der das Halten des Oberflächenkonzentrationswertes sicherstellt, wonach der Durchsatz einer Regelung unterworfen wird, die ihren Wert derart variieren läßt, daß die Oberflächenkonzentration bei dem genannten Wert gleich der Sättigung erhalten wird.

12. Anlage nach Anspruch 11, dadurch gekennzeichnet, daß die Bereitstellmittel der Daten Mittel zur Datenabspeicherung oder Mittel zur Datenberechnung sind.

13. Anlage nach Anspruch 11, dadurch gekennzeichnet, daß die Speisemittel derart konzipiert sind, daß sie dem Ofen ein Verhalten eines perfekt verwirbelten Reaktors verleihen.

## Claims

1. Process for heat or thermochemical treatment of workpieces of a steel material, wherein such workpieces are placed inside a furnace, and maintained at a determined temperature, a gaseous flux, which comprises a carbon yielding constituent including at least one hydrocarbon is caused to circulate in the furnace, and the rate of flow of the carbon yielding constituent in the flux is regulated so as to make at least a first treatment phase causing carbon enrichment of the steel of the workpieces, each first treatment phase causing carbon enrichment of the steel workpieces, each first phase being followed by a second phase causing diffusion of the carbon within the steel,
characterised in that each first phase is divided into two periods immediately following each other,
the first period being determined by the fact that the rate of flow of the carbon yielding constituent has a constant value which allows a thin layer of cementite to form on the surface of the steel, which allows the surface concentration of carbon to be fixed at a value equal to saturation concentration which depends upon the composition of the steel and the temperature, such first period corresponding to the formation of the cementite at the maximum speed associated to said hydrocarbon,
such first period being interrupted by an instantaneous decrease in the carbon yielding constituent flow rate at the moment when the surface concentration reaches a value equal to saturation,
the rate of flow of the carbon yielding constituent being then, during the second period, permanently brought and regulated to an appropriate variable value to maintain the surface concentration at saturation value,
the second period lasting until the end of the first phase.

2. Process according to claim 1, characterised in that the constant value of the carbon yielding constituent flow rate during the first period is such that saturation is obtained after approximately one minute.

3. Process according to claim 1, characterised in that the constant value of the carbon yielding constituent flow rate during the first period is such that said fine layer of cementite is formed at the surface of the steel at the beginning of said first period.

4. Process according to claim 1, characterised in that the gaseous flux comprises, in addition to said carbon yielding constituent, a support made up of nitrogen.

5. Process according to claim 1, characterised in that said gaseous flux comprises, in addition to said carbon yielding constituent, a support made up of hydrogen and nitrogen.

6. Process according to claim 4 or claim 5, wherein the hydrocarbon is propane and the mixture of hydrocarbons contains methane, ethane, acetylene or ethylene.

7. Process according to any of claims 1 to 6, characterised in that the enrichment of the surface with carbon is obtained during the shortest time possible and the surface concentration of carbon is maintained at the highest value possible, whatever the pressure of the gaseous mixture and particularly at atmospheric pressure.

8. Process according to any one of claims 1 to 7, characterised in that the gaseous flux is regulated so as to vary as a function of time according to at least one cycle including a first period during which the flux answers to the condition that the surface concentration of carbon reaches and maintains a first value which is a predetermined limiting value, and a second period during which the addition of carbon is nil, and the surface concentration decreases through diffusion of this carbon in the depth of the workpiece, the duration of this second period being determined by the condition that the surface concentration reaches a second value which is a likewise predetermined prescribed value. concentration reaches a second value which is a likewise predetermined prescribed value.

9. Process according to claim 8, characterised in that the regulation of the flux bears upon the rate of flow of a hydrocarbon contained in a mixture of gases forming said flux.

10. Process according to claim 8 or claim 9, characterised in that the regulation of the flux is effected on the basis of stored data relating to the temperatures, the types of workpieces, the pressures and compositions of the gaseous flux, the data determining the times and the values of regulation of the gaseous flux and the possibility of obtaining a predetermined carbon concentration profile at the surface of the steel workpiece at the theoretical maximum speed.

11. Installation for carbon enrichment of the surface zone of workpieces of a steel material, for implementing the process according to any of claims 1 to 10, comprising:
a atmosphere controlled furnace with an input and outlet for a gaseous flux,
feed means capable of creating in the furnace a flow of a gaseous flux with a support constituent and a carbon yielding constituent formed of at least one hydrocarbon,
manoeuvring means allowing the rates of flow of said constituents to be defined and varied,
means for controlling the manoeuvring means,
and data supply means monitoring said control means,
characterised in that the feed means, the manoeuvring means and the control means are arranged so as to be able to form and regulate the rates of flow and said constituents during a carbon enrichment phase in which the carbon yielding constituent provokes an increase in the surface concentration of the workpieces to a value equal to saturation in approximately one minute, then the rate of flow of the carbon yielding constituent is instantaneously decreased to a value assuring that said surface concentration value is maintained, then said flow rate is subjected to regulation which varies its value so as to maintain the surface concentration at said value equal to saturation.

12. Installation according to claim 11, characterised in that said data supply means are data storage means, or data calculating means.

13. Installation according to claim 11, characterised in that the feed means are designed so as to give the furnace the behaviour of a perfectly agitated reactor.
